Europäisches Patentamt

European Patent Office

Office européen des brevets

(11) Publication number: **0 147 499**
**A2**

(12) # EUROPEAN PATENT APPLICATION

(21) Application number: **84102940.8**

(22) Date of filing: **16.03.84**

(51) Int. Cl.⁴: **H 03 H 7/38**
**H 03 H 5/02**

(30) Priority: **16.03.83 BE 896171**

(43) Date of publication of application:
**10.07.85 Bulletin 85/28**

(84) Designated Contracting States:
**AT BE CH DE FR GB IT LI LU NL SE**

(71) Applicant: **N.V. Machiels-Hanot**
**Stationsstraat 22**
**B-3600 Genk(BE)**

(72) Inventor: **Machiels, Guyllaume Henri**
**Steenweg 175**
**B-3610 Diebenbeek(BE)**

(74) Representative: **Behrens, Dieter, Dr.-Ing. et al,**
**Patentanwälte WUESTHOFF-V.**
**PECHMANN-BEHRENS-GOETZ Schweigerstrasse 2**
**D-8000 München 90(DE)**

(54) **Broadband impedance transformer and resonator.**

(57) A tuned circuit which can be used as a resonator or impedance matching transformer is described. The tuned circuit comprises a first conducting plate, a second conducting plate spaced apart from the first plate and disposed substantially parallel to the first plate and a spiral conductor arranged between the first and second plate. The tuned circuit is useful as a high frequency resonator over a wide frequency range and may serve as an impedance matching transformer for matching a high frequency R.F. generator to a load circuit over a wide frequency range of from several mHz to several hundred mHz.

EP 0 147 499 A2

Croydon Printing Company Ltd.

EP-58 189
Machiels - Hanot, Genk, Belgium

Patentanwälte
Wuesthof·v·Eckmann·
Behrens-Goetz
Schweigerstraße 2
8000 München 90

8410297

## BROADBAND IMPEDANCE TRANSFORMER AND RESONATOR

## BACKGROUND OF THE INVENTION

### 1. Field of the Invention

The present invention relates to the field of radio
frequency (R.F.) generators, and particularly to a tuned
circuit which can be used as an impedance matching
transformer or resonator in conjunction with such
generators. A number of industrial applications of R.F.
energy require an adjustable radio frequency source and
the ability to couple varying frequencies to the load
circuit efficiently. During the industrial process, the
frequency often has to be varied in a range of from 1 to
10 or more.

Linear broadband power amplifiers are characterized by a
low efficiency and cannot be used in high power
industrial applications.

Class-C power amplifiers may be used but are complicated
in construction and cumbersome in use, especially if the
frequency has to be changed continuously.

It is therefore necessary to develop a new kind of tuned circuit that can combine good efficiency and broadband capability  and which permits R.F. generators to be efficiently coupled to load circuits over wide frequency ranges, e.g. from several mHz to several hundred mHz.

## 2.  Description of the Prior Art

Until now two kinds of tuned circuits have been used:

- LC- circuits, consisting of a coil and a separate condenser;

- Transmission line resonators, such as a quarter wavelength of coaxial cable or a resonant cavity.

Transmission line resonators have a much better Q-factor than LC-circuits but their physical dimensions are proportional to their wavelength.  Their application is therefore limited to the highest frequencies, say above 100 MHz.

The need for a broadband tuned circuit has been recognized elsewhere and the following solutions have been proposed.

a)  U.S. Patent 4,295,107 of October 13, 1981 which concerns a broadband impedance transformer with ferrites.  Theoretically, this arrangement may be very good.  It cannot, however, be used in high power applications.

b)  U.S. Patent 3,824,503 of July 16, 1974 which relates to a broadband impedance transformer based on a long tapered transmission line.  This cannot be used in high power applications.

c)  U.S. Patent 3,370,257 of February 20, 1968
which relates to a broadband impedance transformer
with ferrites and coaxial cables. This arrangement
is very complicated and cannot be used for high
power applications.

d)  A whole range of systems that concern the
automation of known manually tuned systems and
adjustments.  These systems have in common that
they are very complicated and impractical for
industrial applications:

-U.S. Patent 3,454,881 of July 8, 1969
"Automatic Tuning Control for H.F. Power
Amplifiers"

-U.S. Patent 3,906,405 of September 16, 1975
"Tunable Antenna Coupling Circuit"

-U.S. Patent 3,959,746 of May 25, 1976
"Automatic Antenna Coupler Tuning Control Circuit"

-U.S. Patent 3,995,237 of November 30, 1976
"Automatic Matching Method and Apparatus"

-U.S. Patent 4,311,972 of January 19, 1982
"High Speed Antenna Coupler"

-U.S. Patent 2,745,067 of May 8, 1956
"Automatic Impedance Matching Apparatus"

-U.S. Patent 3,390,337 of June 25, 1968
"Band Changing and Automatic Tuning Apparatus for
Transmitter T-pad Output Filter"

## SUMMARY OF THE INVENTION

It is an object of the claimed invention to provide a
tuned circuit which can be used as a resonator or
impedance matching transformer for coupling a high
frequency energy source to a load circuit.

It is a further object to provide a tuned circuit which
allows efficient coupling of a wide range of high
frequency electrical energy to a load circuit.

These and other objects of the present invention are
achieved by a tuned circuit comprising first conducting
plate means, second conducting plate means spaced apart
from the first plate means and disposed substantially
parallel to the first plate means, and conductor means
arranged in a spiral between the first and second plate
means.

Other objects, features and advantages of the present
invention will be apparent from the detailed description
which follows.

## BRIEF DESCRIPTION OF THE DRAWINGS

The present invention will be explained in greater
detail in the following detailed description with
reference to the drawings in which:

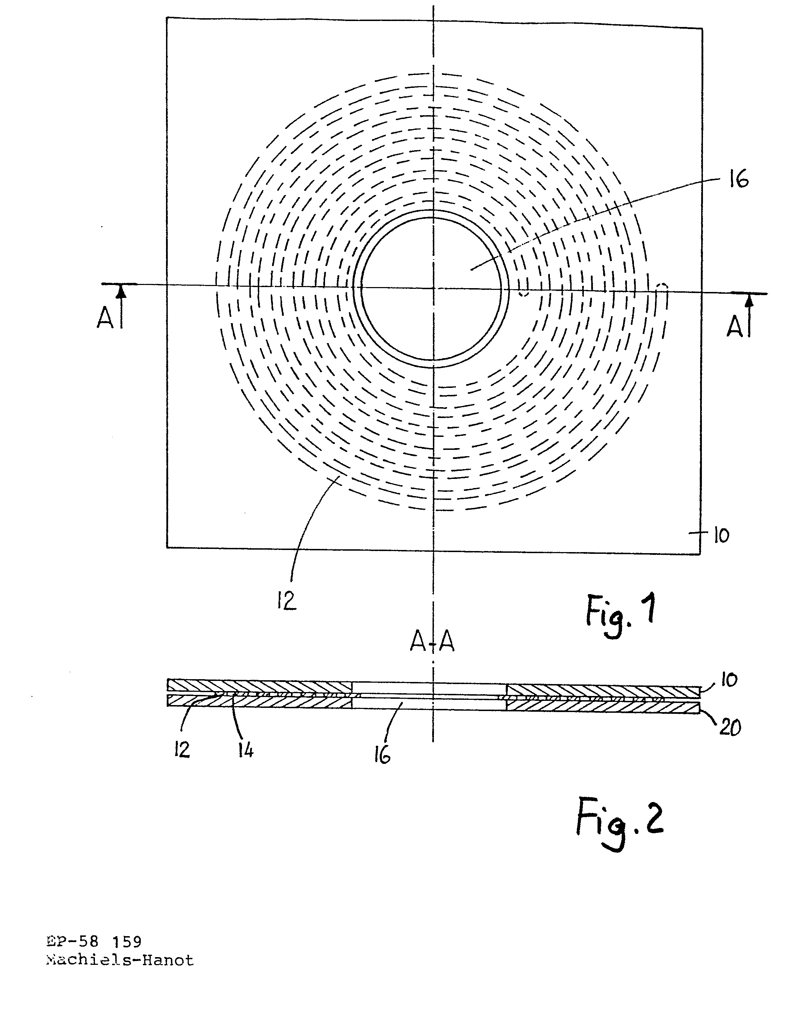

FIG. 1 is a top view of the broadband impedance
transformer and resonator according to the present
invention; and

FIG. 2 is a cross sectional side view taken along line
A-A of FIG. 1.

## DETAILED DESCRIPTION

0147499

### I. Construction

With reference now to the drawings, the impedance transformer and resonator comprises a "sandwich" tuned circuit having two parallel conducting plates 10 and 20 between which is interposed a spiral 12 of conducting material. The cavity 14 between the plates is filled with high quality insulating material that also gives the necessary mechanical strength to the whole unit.

The electrical characteristics of the tuned circuit depend on its geometrical form and dimensions. The spiral may have the form of a watch spring. That is, a conducting strip wound around an axis that is parallel to the flat side of the strip. It also can be a flat spiral so that the flat side of the conducting strip lies in a plane perpendicular to the axis of the spiral.

The factors influencing the electrical properties of the tuned circuit are:

1) The distance between the parallel plates.

2) The breadth, or thickness of the spiral conducting strip.

3) The thickness or breadth, of the spiral in the radial dimension.

4) The variation of the above dimensions as a function of the radius of the spiral.

5) The total length of the spiral.

0147499

## II. Operation

The operating principles of the tuned circuit are most easily understood if one considers the space between the two parallel plates as a cavity resonator. The electromagnetic field in this cavity can, due to the presence of the spiral, oscillate only in a number of well defined modi.

Near the surface of the two parallel conducting plates, sudden electric potential variations are not possible. The electric field near the surface and parallel to the surface must be a sinusoidal function of distance in every direction. The same is true for the electric field near the surface of the spiral. The electric field tangential to the spiral can vary only sinusoidally as a function of the distance along the spiral. Because both fields, the one at the surface of the parallel plates and the one at the surface of the spiral, are in fact one and the same field, there exists a kind of interference between the possible modi of oscillation. Moreover, the conditions imposed at the extremities of the spiral, potentials or exterior impedances connected between or imposed at the extremities of the spiral, and the exterior parallel plates limit further the number of possible modi.

## III. Characteristics

### 1. As a Resonator

If one of the extremities of the spiral, either the central one or the exterior one, is short-circuited to the exterior plates, the other extremity of the spiral will behave as an impedance that depends on the frequency that is supplied. The impedance value will show maxima and minima for a range of frequencies that resembles a harmonic series and is in fact an approximation of an harmonic series. Depending on the kind of construction the following series can be approximated:

A. A series of odd harmonics;

B. A series of even harmonics;

C. All harmonics, even plus odd;

D. A series with split maxima, in which every odd harmonic is split into two peaks, the odd harmonic itself being a minimum. The separation between the peaks depends on the construction of the spiral. In fact, by gradual modifications of the kind of construction, it is possible to change A gradually into D,D into C,C into B and conversely.

The geometrical form of the spiral shown in the drawings is given by the formula

$$r = a \cdot \theta$$

where a is a constant, r is the radius and $\theta$ is the angle about the spiral axis.

The frequency of resonance depends almost exclusively on the developed length of the spiral. The impedance of the circuit depends on two ratios, the ratio e/d, e being the spacing of the condenser plates and d being the conductor diameter, and the ratio e/a.

0147499

A "sandwich" tuned circuit has a series of resonant frequencies, as has a transmission line resonator, and can be adapted to a broad range of impedances, as can an LC-circuit. Within its range of applications a sandwich tuned circuit has a better Q than an LC-circuit and is much smaller than a coaxial resonator.

## 2. As an Impedance Transformer

If one of the extremities of the spiral is connected to a given load, the other extremity behaves as a frequency dependent impedance. If the impedance transformer has been constructed according to III 1A above, the transformation ratio can vary between 1 to 1 and 1 to 10,000 with exterior impedances in the range of a fraction of an ohm to tens of kilo-ohms.

A "sandwich" tuned circuit can be used as a quarter wave, or a multiple quarter wave, resonator and impedance transformer if the effects of "parasitic capacity" between windings and of mutual inductance between adjacent windings can be offset. If m is the mutual conductance per unit of length and if c is the parasitic capacity between adjacent windings per unit length r, it can be shown theoretically, and it has been shown experimentally, that the "sandwich" circuit will behave as an orthodox transmission line if the geometry of the circuit is such that the following relation is satisfied, Z being the characteristic impedance of the spiral:

$$m/c = z^2$$

0147499

The "sandwich" tuned circuit will behave as a tapered transmission line, and can be used as such as an impedance transformer, if "a" in the expression for r is a function of  and if the total spiral length is adapted.

The region of application of the circuit may be as wide as from 1 MHz to 500 MHz. When high power or high Q considerations impose large conductor sizes, conductor bending is a problem above about 100 MHz and a coaxial circuit will give a better Q and handle more power, where as the "sandwich" circuit will be more compact. At the lower frequency end the reverse is true, an LC-circuit being more compact and the "sandwich" circuit having a better Q and a better power handling capacity than an LC-circuit.

Another important characteristic of the "sandwich" tuned circuit is its ability to adapt to a very broad range of characteristic impedances, from a few ohms to several kilo-ohms, whereas transmission line circuits are limited to about 150 ohms.

Electrically, a "sandwich" tuned circuit behaves as a series arrangement of parallel LC-circuits. The resonance frequencies of these tuned circuits are almost, but not exact, odd harmonics of a common fundamental frequency. he behavior of the circuit is similar in this respect to the behavior of a resonant quarter wave.

## 3. As an Impedance Adapter

0147499

The tuned circuit, when used as an impedance transformer, behaves as a frequency dependent impedance in a way similar to an LC-circuit. Therefore this impedance transformer can be used as an impedance adapter for neutralizing unwanted reactancies such as are encountered in power amplifiers. This adaption can be obtained simultaneously with an impedance transformation or independently.

## IV. Advantages

## 1. Efficiency

A) A normal, class A, broadband amplifier has an efficiency of about 25%. The present invention creates the possibility of building broadband power amplifiers with class C characteristics, that is, with efficiencies of around 80%.

B) In the frequency range where cavity resonators are too large to be used as tuning circuits and where, for this reason, LC-circuits have to be used, a better Q-factor, and lower losses, can be obtained with this circuit, than is possible with traditional LC-circuits.

The "sandwich" tuned circuit has a Q-factor similar to or better than a coaxial resonator. Theoretically its physical dimensions are independent of wavelength. In the contract to a coaxial resonator, it is useful in the region between a few MHz to a few hundreds of MHz.

## 2.  Economy of Available Space

0147499

For the same frequency and the same power the impedance transformer and resonator of the present invention is far less bulky than either a cavity resonator or an LC-circuit.

An important advantage of this type of circuit is the fact that it fits well, mechanically and electrically, around high power transmitting tubes.  A power tube can easily be built into a center aperture 16 of the tuned circuit in such a way that both together constitute a single compact unit.

The three "discs" of the sandwich, i.e., the two plates and the spiral, may carry very different D.C. potentials.  A modern "coaxial" transmitting tube fits well, coaxially, into the "sandwich".  The discs of the sandwich can support the electrode contact rings of the tube without interfering with the cooling system and while keeping the electrode stray capacitance at a minimum.

In this respect a "sandwich" tuned circuit is very superior to either a resonant transmission line or a tuned circuit with "lumped" elements.  In the frequency region described above a "sandwich" circuit will always result in a very compact and high performance amplifier stage.  In the high power case other circuits will require more space and will implicate more energy losses, in the circuit itself as well as by stray losses.

## 3. Possibilities of Production                    0147499

The construction of this device is quite simple because
it comprises only three basic parts that are flat.
Electrically, the characteristics of the impedance
transformer may be easily controlled.

Because all parts are flat it is possible to build
transformers that are mathematically complicated, with
simple tooling equipment.  In this way unusual
electrical characteristics, such as described above, can
be obtained easily.

## 4. Possibilities of New Applications

The present invention creates the possibility of
economizing space or energy or both by the replacement
of traditional LC-circuits by the present circuit.  It
also creates the possibilities for quite new
applications.

A whole frequency range, e.g., from approximately 5 to
200 MHz, can be utilized with a single circuit without
the necessity of changing taps or tuning settings.  It
is possible to change frequency of the amplifier while
operating and at full load.

The impedance transformer and resonator of the present
invention is a device that is mechanically simple, is
less bulky, and gives a better quality than the circuits
it is intended to replace, LC-circuits or cavity
resonators.

0147499

The invention also creates the possibility of building broadband high power R.F. amplifiers from narrow band class C amplifiers. Bandwidths of 1. 9 times the central frequency have been attained without appreciable losses of energy.

In the foregoing specification, the invention has been described with reference to specific exemplary embodiments thereof. It will, however, be evident that various modifications and changes may be made thereunto without departing from the broader spirit and scope of the invention as set forth in the appended claims. The specification and drawings are, accordingly, to be regarded in an illustrative rather than a restrictive sense.

WHAT IS CLAIMED IS:                          0147499

84 10 2940-8

1. A tuned circuit comprising:

   first conducting plate means;

   second conducting plate means spaced apart from
   said first plate means and disposed substantially
   parallel to said first plate means;

   conductor means arranged in a spiral between said
   first and second plate means.

2. The tuned circuit recited in claim 1, further
   comprising insulating means disposed between said
   first and second plate means.

3. The tuned circuit recited in claim 1 wherein said
   first and second plate means include aperture
   means, said conductor means arranged around said
   aperture means between said first and second plate
   means, whereby a power electron tube of a high
   frequency generator may be disposed in said
   aperture means, said tuned circuit coupling said
   electron tube to a load circuit to which high
   frequency energy is to be applied.

4. The tuned circuit recited in claim 1 wherein said
   conductor means comprises a flat ribbon conductor,
   the flat side of said ribbon conductor being
   parallel to a line perpendicular to said first and
   second plate means.

5. The tuned circuit recited in claim 1 wherein said
   conductor means comprises a flat ribbon conductor,
   the flat side of said ribbon conductor being
   parallel to said first and second plate means.

6.  An impedance transformer comprising:     0147499

    first conducting plate means;

    second conducting plate means spaced apart from
    said first plate means and disposed substantially
    parallel to said first plate means;

    conductor means arranged in a spiral between said
    first and second plate means.

7.  The impedance transformer recited in claim 6,
    further comprising insulating means disposed
    between said first and second plate means.

8.  The impedance transformer recited in claim 6
    wherein said first and second plate means include
    aperture means, said conductor means arranged
    around said aperture means between said first and
    second plate means, whereby a power electron tube
    of a high frequency generator may be disposed in
    said aperture means, said impedance transformer
    coupling said electron tube to a load circuit to
    which high frequency energy is to be applied.

9.  The impedance transformer recited in claim 6
    wherein said conductor means comprises a flat
    ribbon conductor, the flat side of said ribbon
    conductor being parallel to a line perpendicular to
    said first and second plate means.

10. The impedance transformer recited in claim 6
    wherein said conductor means comprises a flat
    ribbon conductor, the flat side of said ribbon
    conductor being parallel to said first and second
    plate means.

16

A

A

10

12

Fig. 1

A‑A

10

20

12    14    16

Fig. 2

EP-58 159
Machiels-Hanot